(19) Europäisches Patentamt
European Patent Office
Office européen des brevets

(11) **EP 2 828 976 B1**

(12) **FASCICULE DE BREVET EUROPEEN**

(45) Date de publication et mention
de la délivrance du brevet:
**02.03.2016 Bulletin 2016/09**

(21) Numéro de dépôt: **13711381.7**

(22) Date de dépôt: **21.03.2013**

(51) Int Cl.:
*H04B 1/408* (2015.01)      *H01L 23/66* (2006.01)
*H01L 25/16* (2006.01)      *H04B 1/04* (2006.01)
*H01Q 23/00* (2006.01)

(86) Numéro de dépôt international:
**PCT/EP2013/055987**

(87) Numéro de publication internationale:
**WO 2013/139939 (26.09.2013 Gazette 2013/39)**

(54) **SYSTEME D'EMISSION-RECEPTION EN BANDE MILLIMETRIQUE**

MILLIMETERBAND-SENDE-/EMPFANGSSYSTEM

MILLIMETRE BAND TRANSMITTING/RECEIVING SYSTEM

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.03.2012 FR 1252650**

(43) Date de publication de la demande:
**28.01.2015 Bulletin 2015/05**

(73) Titulaire: **COMMISSARIAT A L'ENERGIE
ATOMIQUE ET AUX
ENERGIES ALTERNATIVES
75015 Paris (FR)**

(72) Inventeurs:
• **DEHOS, Cédric
F-29100 Douarnenez (FR)**

• **DUSSOPT, Laurent
F-38100 Grenoble (FR)**
• **SILIGARIS, Alexandre
F-38100 Grenoble (FR)**
• **VINCENT, Pierre
F-38250 Villard de Lans (FR)**

(74) Mandataire: **Bréda, Jean-Marc et al
Marks & Clerk France
Conseils en Propriété Industrielle
Immeuble " Visium "
22, avenue Aristide Briand
94117 Arcueil Cedex (FR)**

(56) Documents cités:
EP-A1- 0 476 675      EP-A2- 1 162 754
EP-A2- 1 486 796      WO-A2-00/74170
US-A1- 2011 254 727

EP 2 828 976 B1

**Description**

L'invention concerne les systèmes d'émission-réception en bande millimétrique destinés à transmettre et recevoir des données à haut débit entre deux appareils non reliés électriquement mais proches ou très proches l'un de l'autre (de quelques millimètres à quelques mètres).

Les applications de ces systèmes sont la transmission de données à haut débit entre deux dispositifs mobiles (deux téléphones portables par exemple) ou un dispositif mobile et un dispositif fixe (un téléphone portable et un ordinateur par exemple), la transmission sans contact entre deux puces électroniques ou deux cartes à puces, la transmission d'un flux vidéo entre un boîtier de raccordement au réseau internet (set top box) et un récepteur de télévision, etc.

La bande millimétrique considérée dans cette invention est une bande de fréquence généralement appelée bande de 60 GHz, c'est-à-dire des fréquences porteuses hertziennes situées entre 57 et 66 GHz, mais l'invention serait applicable à d'autres bandes de fréquence, aussi bien au-dessous de 57 GHz qu'au-dessus de 66 GHz, par exemple de 10 à 100 GHz.

Dans ce qui suit on parlera pour simplifier de signal à 60GHz pour qualifier le signal radiofréquence émis ou reçu par voie hertzienne.

Dans l'art antérieur on a proposé des réalisations qui diffèrent les unes des autres selon la portée de transmission désirée.

Lorsque la portée est très courte, de l'ordre de quelques millimètres, chaque carte possède un circuit intégré d'émission-réception relié à une antenne respective. C'est le cas par exemple lorsqu'on veut établir une communication entre deux cartes à puces : on les approche tout près l'une de l'autre et leurs antennes se trouvent à quelques millimètres au maximum l'une de l'autre. Les circuits d'émission-réception et les antennes remplacent en quelque sorte une connexion électrique par contact direct. La publication de brevet US2010159829 et le brevet US 7,808,798 décrivent des circuits d'émission-réception dans ce contexte.

Lorsque la portée est plus longue (plusieurs dizaines de centimètres à plusieurs mètres) on a déjà proposé d'émettre ou recevoir le signal radiofréquence en parallèle sur N voies reliées respectivement à N antennes ; un effet de formation de faisceau directif est produit par un contrôle des déphasages de la fréquence porteuse dans chacune des voies.

Pour l'émission, un processeur engendre un signal de modulation en bande de base, qui est ensuite transposé en fréquence par un émetteur radiofréquence à 60GHz. Le signal est ensuite divisé sur N voies par des diviseurs de puissance, puis déphasé sélectivement sur chaque voie et amplifié pour être conduit jusqu'à une antenne respective.

De même, à la réception, un réseau de N antennes (qui peuvent être les mêmes que les antennes d'émission) reçoit le signal et l'amène à une série de N amplificateurs et déphaseurs ; les déphaseurs tendent à compenser individuellement les différences de phase des signaux reçus par les différentes antennes dans une direction de l'espace ; les signaux déphasés sont recombinés par un combineur (analogue au diviseur de puissance qui sert à l'émission mais fonctionnant dans le sens inverse), avant d'entrer dans un récepteur radiofréquence, lequel effectue la transposition de fréquence vers la bande de base, puis dans le processeur de traitement du signal.

Dans cette architecture, on réunit sur une même puce de circuit-intégré le processeur de signal qui engendre le signal radiofréquence ou qui reçoit le signal recombiné, le répartiteur de puissance, le combineur, et chacun des circuits d'émission-réception qui déphasent sélectivement et amplifient le signal émis ou reçu par une antenne respective. Les antennes sont de préférence réalisées en dehors du circuit intégré en raison du fait que le substrat de silicium du circuit intégré ne se prête pas bien à un usage d'antenne (il est en général trop conducteur). Les antennes peuvent être formées sur un support de circuit imprimé standard, en matière plastique ou céramique, sur lequel est reporté le circuit intégré.

Cette architecture à formation de faisceau pour une communication à longue portée conduit à une puce de circuit-intégré de grande surface et donc coûteuse, qui peut être acceptable pour une communication à longue portée mais inacceptable pour une communication à courte ou moyenne portée car cette dernière peut être réalisée avec une puce de circuit-intégré beaucoup moins chère. De plus, cette architecture n'est pas versatile : il faut refaire un développement coûteux pour chaque nouvelle application. La publication de brevet US20090061795 décrit un exemple d'une telle architecture. EP 1 486 796 décrit un système d'émission-réception pour radar à formation de faisceau ; EP 1 132 754, décrit un terminal de téléphonie mobile fonctionnant selon plusieurs modes ; et US 2011/254527 décrit un système d'imagerie en bande millimétrique;

L'invention a pour but de proposer une architecture différente permettant de réduire les coûts de conception et d'optimiser les coûts de mise en oeuvre d'un système d'émission-réception en bande millimétrique. Elle peut servir même pour des applications à courte portée. Dans cette architecture nouvelle, on va associer un circuit intégré d'émission-réception à chaque antenne ; les circuits intégrés recevront un signal de modulation en bande de base et effectueront individuellement un déphasage contrôlé du signal puis une transposition vers la fréquence porteuse à partir d'une synthèse de fréquence faite dans le circuit lui-même.

A cet effet, l'invention propose un système d'émission-réception en bande millimétrique sans contact pour une transmission de données à haut débit, comprenant un circuit de traitement commun fournissant des signaux de modulation et plusieurs circuits intégrés d'émission-réception tous identiques les uns aux autres, reliés électriquement au circuit de traitement commun pour en recevoir les signaux de modulation et recevant par ailleurs tous un signal d'horloge issu d'une source de signal d'horloge commune, les circuits intégrés d'émission-réception comportant chacun :

- un oscillateur asservi sur le signal d'horloge pour produire une fréquence porteuse multiple du signal d'horloge,
- une voie d'émission comportant un premier circuit de déphasage commandable, un premier circuit de transposition de fréquence vers la fréquence porteuse, et un amplificateur de puissance,
- une voie de réception comportant un amplificateur à faible bruit, un deuxième circuit de transposition de fréquence depuis la fréquence porteuse, et un deuxième circuit de déphasage commandable,

le système comportant également pour chaque circuit intégré d'émission-réception au moins une antenne respective reliée aux voies d'émission et de réception de ce circuit.

Par conséquent, le système ne comporte pas de circuit commun qui aurait un oscillateur unique asservi sur le signal d'horloge et un circuit de transposition de fréquence unique entre la bande de base et la fréquence porteuse. Au contraire, il y a un oscillateur et un circuit de transposition dans chaque circuit intégré d'émission-réception. Seule l'horloge est commune et sert d'horloge de référence. Le signal de modulation qui est dirigé vers les différents circuits d'émission-réception est en bande de base et non à la fréquence porteuse ; il n'est donc pas nécessaire de prévoir de répartiteur de puissance ou de combineur à la fréquence porteuse pour aiguiller les signaux modulés vers chacun des déphaseurs d'émission ou pour recombiner les signaux issus des déphaseurs de réception. Enfin, dans l'architecture selon l'invention, les déphaseurs fonctionnent en bande de base et non à la fréquence porteuse.

L'oscillateur présent dans chaque circuit intégré est de préférence une boucle à asservissement de phase (PLL) recevant le signal d'horloge.

L'antenne est de préférence située en dehors du circuit intégré d'émission-réception auquel elle est associée. Elle est reliée à une borne d'entrée/sortie du circuit intégré, qui est une borne de connexion d'antenne servant aussi bien pour l'émission que pour la réception.

Cette borne de connexion est de préférence reliée à un commutateur émission/réception faisant partie du circuit intégré d'émission-réception ; ce commutateur permet de relier l'antenne soit à la sortie de l'amplificateur de puissance de la voie d'émission soit à l'entrée de l'amplificateur à faible bruit de la voie de réception.

De préférence, les circuits intégrés d'émission-réception sont reportés sur une face arrière d'une plaquette de silicium à haute résistivité comportant sur cette face arrière un réseau de conducteurs d'interconnexion reliés aux circuits intégrés, les antennes étant formées sur la face avant et étant reliées au réseau de conducteurs par des vias conducteurs traversant toute l'épaisseur de la plaquette. La plaquette de silicium est de préférence elle-même reportée sur une plaque de circuit imprimé.

De préférence encore, chaque circuit-intégré d'émission-réception comporte un contrôle de gain à l'émission et à la réception pour optimiser la consommation lorsqu'il n'est pas nécessaire d'utiliser toute la puissance d'émission disponible. L'alimentation électrique de chacun des circuits d'émission-réception ou au moins des amplificateurs d'émission et de réception, peut aussi être coupée s'il n'est pas nécessaire d'utiliser tous les circuits en émission ou en réception, par exemple dans le cas de bonnes conditions de communication.

Le fait que la fréquence porteuse soit produite séparément dans chaque circuit d'émission-réception induit un risque que les différentes fréquences porteuses ne soient pas toutes en phase. Par conséquent, les commandes de déphasage appliquées par le circuit commun pour ajuster le diagramme de rayonnement global risquent d'aboutir en réalité à des déphasages qui ne sont pas les déphasages souhaités.

Il est donc souhaitable de calibrer le système pour compenser les déphasages intrinsèques introduits par les oscillateurs asservis soit en raison de leur constitution, soit en raison des positions géographiques des circuits intégrés dans le système.

C'est pourquoi le système comprend de préférence des moyens de calibration pour déterminer, dans une phase de calibration, les déphasages propres des fréquences porteuses produites par les différents circuits intégrés. La phase de calibration peut être unique ou répétée régulièrement à chaque nouvelle communication entre deux systèmes, ou même répétée au cours des communications réelles entre les systèmes.

Dans une version préférée, les moyens de détermination des déphasages de fréquence porteuse comprennent, dans le cas où il y a N circuits intégrés d'émission-réception :

- des moyens pour appliquer à la voie d'émission des N circuits une séquence de N échantillons successifs de signaux de test, représentée par un vecteur X à N composantes,
- des moyens pour appliquer un jeu de N déphasages simples aux N circuits de déphasage des voies d'émission au moment de l'émission d'un échantillon, le jeu de N déphasages simples étant choisi parmi N jeux possibles différents les uns des autres et orthogonaux les uns par rapport aux autres, les N jeux étant appliqués successivement en synchronisme avec l'application des N échantillons de la séquence,

- des moyens pour recueillir un vecteur Y de N échantillons successifs de signal correspondants sur la voie de réception couplée à la voie d'émission,
- et des moyens pour calculer un vecteur $\Phi$ de déphasages des fréquences porteuses des N circuits par une équation $\Phi = (1/2N)^tH.Y \otimes (1/X)$, où $^tH$ désigne la transposée d'une matrice H représentant les N jeux possibles de N déphasages, 1/X désigne un vecteur dont les composantes sont l'inverse de chacune des composantes du vecteur X, et le symbole $\otimes$ désigne une multiplication terme à terme des composantes de vecteurs, le point représentant une multiplication matricielle.

Les vecteurs de la matrice H sont orthogonaux vis-à-vis du produit scalaire canonique.

L'invention concerne également un procédé d'utilisation d'un système d'émission-réception en bande millimétrique sans contact pour une transmission de données à haut débit, comprenant un circuit de traitement commun fournissant des signaux de modulation et plusieurs circuits intégrés d'émission-réception tous identiques les uns aux autres, reliés électriquement au circuit de traitement commun pour en recevoir les signaux de modulation et recevant par ailleurs tous un signal d'horloge issu d'une source de signal d'horloge commune, les circuits intégrés étant reliés chacun à au mois une antenne respective et comprenant chacun une boucle à asservisssement de phase, des circuits de transposition de fréquence et des circuits de déphasage commandables, procédé caractérisé en ce qu'il comprend une étape de calibration pour la détermination de déphasages propres des différents circuits-intégrés, liés à la constitution et à la position des circuits intégrés dans le système, une mise en mémoire de ces déphasages, et une utilisation ultérieure des déphasages mis en mémoire, pour modifier des commandes de déphasage fournies aux circuits intégrés par le circuit de traitement commun.

D'autres caractéristiques et avantages de l'invention apparaîtront à la lecture de la description détaillée qui suit et qui est faite en référence aux dessins annexés dans lesquels :

- la figure 1 représente l'architecture générale du circuit intégré selon l'invention ;
- la figure 2 représente la constitution d'un circuit-intégré individuel d'émission-réception ;
- la figure 3 représente une constitution possible de déphaseur ;
- la figure 4 représente une réalisation physique du système.

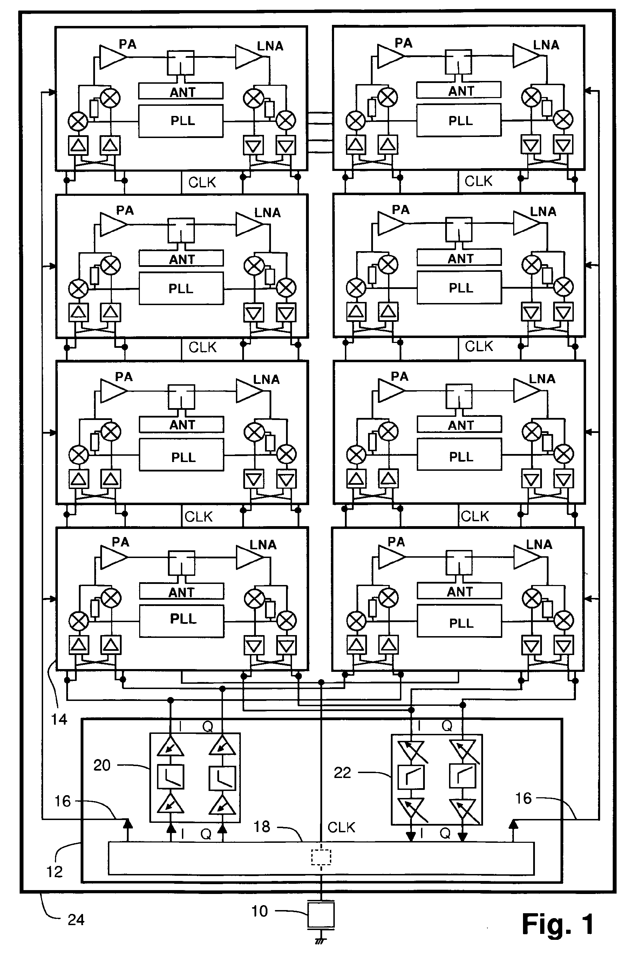

L'architecture générale du système d'émission-réception selon l'invention est représentée à la figure 1, dans une configuration exemplaire dans laquelle il y a huit antennes d'émission permettant une formation de faisceau par action sur les déphasages relatifs des fréquences porteuses émises par les huit antennes.

Par l'expression formation de faisceau, on entend ici une action sur le diagramme de rayonnement global de l'ensemble formé par les huit antennes émettant un même signal modulé ou recevant un même signal. Le diagramme est directif, avec en principe un lobe principal dans une direction donnée ; un choix approprié des déphasages relatifs des fréquences porteuses émises par les différentes antennes permet de modifier la direction du lobe principal.

Les normes existantes de communication en bande millimétrique prévoient un protocole de formation de faisceau au début d'une communication entre deux systèmes, et un protocole de suivi au cours de la communication, pour ajuster le diagramme de rayonnement de chaque système en fonction des positions relatives des deux systèmes, de telle manière que la puissance reçue par chaque système soit toujours maximisée.

Le système d'émission-réception comporte au moins les éléments suivants :

- un premier circuit intégré 12 qui sert au traitement des signaux de modulation en bande de base ainsi qu'au contrôle de tous les autres circuits intégrés, notamment pour fournir des signaux de commande (en principe numérique) de déphasage à chacun d'eux ;
- une source de fréquence d'horloge stable, réalisée en principe dans le circuit intégré 12 et stabilisée par un quartz 10 extérieur au circuit intégré ; la fréquence d'horloge est une très basse fréquence si on la compare avec les fréquences porteuses d'environ 60 GHz émises ou reçues par le système ; elle peut être par exemple de 36 MHz ; le signal d'horloge CLK produit par cette source sert à tout le système pour le cadencement des opérations d'une part et pour la stabilisation de la fréquence porteuse d'autre part ;
- N circuits intégrés 14, (huit sur la figure 1) qui sont des circuits d'émission-réception, comprenant chacun au moins un oscillateur (PLL) à boucle d'asservissement de phase, calé sur le signal d'horloge CLK, des circuits de transposition de fréquence, des déphaseurs fonctionnant en bande de base, un amplificateur de puissance (PA) pour l'émission et un amplificateur à faible bruit (LNA) pour la réception,
- N antennes d'émission-réception ANT, reliées chacune à un circuit d'émission-réception respectif ; en raison du manque de place sur la figure 1, les antennes sont représentées pour simplifier comme si elles faisaient partie du circuit d'émission-réception, mais dans la pratique elles ne font pas partie du circuit intégré d'émission-réception : elles sont reliées à une borne d'entrée/sortie d'antenne du circuit intégré. Elles pourraient cependant dans certains cas être formées sur leur circuit-intégré d'émission-réception respectif.

On considérera dans la suite qu'il y a N antennes jouant à la fois le rôle d'antenne d'émission et d'antenne de réception, mais on pourrait aussi envisager qu'il y a 2N antennes, une antenne d'émission et une antenne de réception séparées étant associées à chaque circuit-intégré d'émission et de réception.

Le signal d'horloge commun CLK est appliqué par le circuit de traitement 12 à chacun des circuits intégrés d'émission-réception 14.

Le déphasage de chacun des deux déphaseurs de chaque circuit intégré 14 est commandable. C'est le circuit de traitement 12 qui le commande ; des connexions de commande numérique 16 relient à cet effet le circuit de commande à chacun des circuits intégrés 14.

Le circuit intégré 12 peut comprendre à la fois un processeur numérique de commande et des circuits de traitement du signal de modulation en bande de base émis ou reçu. Sur la figure 1, on a inclus dans le circuit intégré commun 12 un processeur numérique 18, un circuit 20 d'amplification, de contrôle de gain, et de filtrage à l'émission, et un circuit 22 d'amplification, de contrôle de gain, et de filtrage à la réception. Mais on peut prévoir aussi que ces différentes fonctions sont réalisées par des circuits intégrés distincts. Lorsque les signaux de modulation sont produits ou reçus par le système sous forme numérique en vue d'une émission radiofréquence, c'est le circuit 12 qui les convertit en signaux analogiques en bande de base ; de même à la réception, c'est le circuit 12 qui, après amplification et filtrage en bande de base, les reconvertit en signaux numériques.

Les signaux à émettre depuis le circuit 20 vers les différents circuits intégrés 14 sont de préférence envoyés sous forme de deux signaux en bande de base en quadrature de phase [I, Q]. Ils sont envoyés au circuit 20 sous cette forme par le circuit de traitement de signaux 18. Il en est de même à la réception : les signaux sont reçus des circuits 14 sous forme de signaux en quadrature [I, Q] et de là sont transmis au circuit de traitement 12 sous cette forme. Chaque circuit intégré 14 possède donc une entrée double pour les signaux en quadrature [I, Q] qu'il doit émettre vers son antenne respective, et une sortie double pour les signaux en quadrature qu'il a reçu.

De préférence, le circuit intégré de traitement 12, les circuits intégrés d'émission-réception 14, sont reportés sur une plaquette commune 24 en silicium de haute résistivité. Cette plaquette 24 comporte un réseau d'interconnexions conductrices qui sont de préférence sur une des faces de la plaquette qu'on appellera face arrière, et les antennes ANT sont formées sur la face avant de cette plaquette. Le réseau d'interconnexions sert notamment à réaliser toutes les connexions visibles sur la figure 1 entre le circuit de traitement 12 et les circuits d'émission-réception 14. Les antennes sont de préférence reliées à ce réseau ou directement aux circuits d'émission-réception 14 par l'intermédiaire de vias conducteurs percés entre la face avant et la face arrière de la plaquette de silicium. La plaquette peut elle-même être reportée sur une plaque de circuit imprimé et le quartz peut être sur cette plaque. On reviendra plus loin sur cette constitution physique.

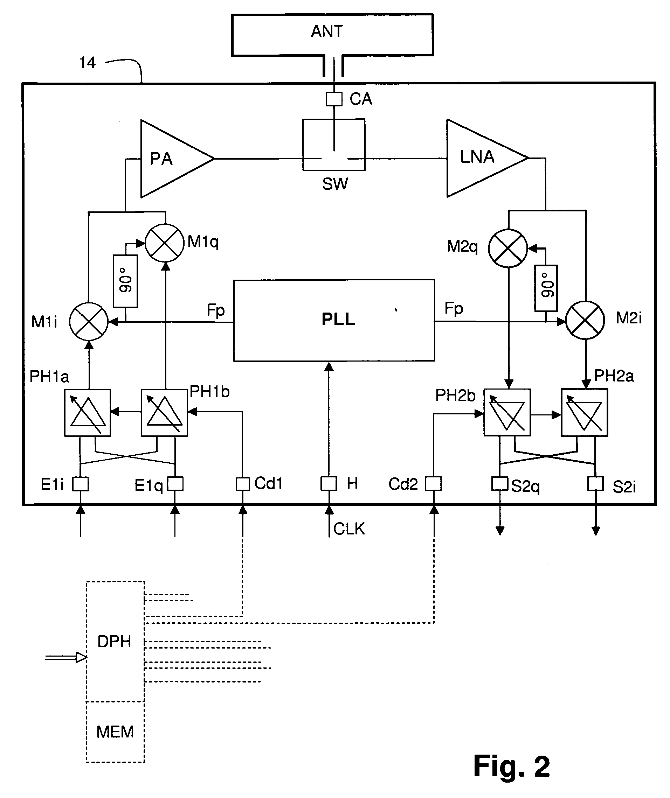

La figure 2 représente le détail d'un circuit intégré d'émission-réception 14. Le circuit intégré comporte les bornes d'entrée/sortie suivants :

- bornes d'entrée E1i et E1 q pour recevoir du circuit intégré de traitement de signaux 12 des signaux modulés en bande de base, en quadrature de phase, qui seront transposés en radiofréquence avant d'être émis par une antenne ; toutes les bornes E1i des différents circuits intégrés 14 reçoivent un même premier signal, avec cependant une possibilité de déphasage les unes par rapport aux autres en raison de la distance variable entre le circuit 12 et les différents circuits 14 ; de même, toutes les bornes E1 q reçoivent du circuit 12 un même deuxième signal en quadrature de phase avec le précédent ;
- bornes de sortie S2i, S2q pour transmettre au circuit de traitement 12 des signaux modulés, reçus en radiofréquence par l'antenne et transposés en bande de base ; toutes les bornes de sortie S2i sont reliés à une même entrée du circuit 12, et de même toutes les bornes de sortie S2q ;
- borne d'horloge H recevant du circuit 12 (ou d'ailleurs) un signal d'horloge CLK qui est le même pour tous les circuits 14 ;
- borne ou groupe de bornes Cd1 recevant du circuit de traitement 12 un signal de commande de déphasage pour commander le déphasage des signaux en bande de base reçus sur les entrées E1i et E1 q ; le déphasage est le même sur les voies I et Q ; ce signal de commande agit sur un circuit déphaseur qui est, dans cet exemple sur lequel on reviendra plus loin, composé de deux parties PH1a et PH1b ; le signal de commande de déphasage reçu sur la borne Cd1 est individuel à chaque circuit intégré 14, c'est-à-dire que le circuit de traitement 12 peut forcer un déphasage différent sur chaque circuit intégré 14 ;
- borne ou groupe de bornes Cd2 recevant du circuit de traitement 12 un signal de commande de déphasage pour commander le déphasage des signaux en bande de base avant application sur les sorties S1i et S1 q ; le déphasage est le même sur les voies I et Q ; ce signal de commande agit sur un circuit déphaseur représenté ici sous forme de deux parties PH2a et PH2b pour les voies I et Q respectivement ; le signal de commande de déphasage reçu sur la borne Cd2 est là encore individuel à chaque circuit intégré 14, le circuit de traitement 12 pouvant forcer un déphasage différent sur chaque circuit intégré 14 ;

- borne de connexion d'antenne CA à laquelle est raccordée une antenne ANT extérieure au circuit intégré 14 ; cette borne est reliée, à l'intérieur du circuit 14 à un commutateur d'antenne SW qui bascule selon qu'on est en mode d'émission de signaux ou en mode de réception de signaux.

Le déphasage appliqué à l'intérieur d'un circuit intégré résulte de deux composantes qui sont une composante de déphasage propre liée à la constitution et à la position du circuit intégré dans le système, et une composante de déphasage de formation de faisceau liée à la directivité qu'on souhaite donner au diagramme de rayonnement global de l'ensemble des antennes. Les déphasages propres résultent notamment des longueurs différentes des connexions qui transportent l'horloge commune H ; ils peuvent résulter aussi des différences de caractéristiques des circuits intégrés et notamment des boucles à asservissement de phase de ces circuits. Le déphasage propre s'entend comme étant le déphasage entre les signaux de sortie du circuit de traitement commun et l'antenne du circuit intégré.

Le commutateur d'antenne SW a deux états possibles : état d'émission dans lequel il reçoit des signaux en bande millimétrique de la sortie d'un amplificateur de puissance PA pour les transmettre sur la borne CA ; état de réception dans lequel il transmet des signaux reçus par l'antenne vers l'entrée d'un amplificateur à faible bruit LNA.

L'entrée de l'amplificateur de puissance PA est reliée à la sortie d'un circuit de transposition de fréquence qui transpose vers la bande millimétrique les signaux modulés qui ont été reçus par les entrées E1i et E1q et qui ont été déphasés par le déphaseur commandé PH1a, PH1b. Le circuit de transposition de fréquence comprend essentiellement un mélangeur ; comme deux signaux en quadrature de phase sont reçus, il y a en pratique deux mélangeurs M1i et M1q dont les sorties sont recombinées pour regrouper les signaux à l'entrée de l'amplificateur PA.

Les mélangeurs M1i et M1q reçoivent chacun une fréquence porteuse en bande millimétrique produite par un oscillateur à boucle d'asservissement de phase PLL. La fréquence porteuse est appliquée en phase au mélangeur M1i et en quadrature de phase à l'autre mélangeur M1q ; c'est pourquoi un déphaseur de 90° est représenté sur la figure ; l'oscillateur pourrait aussi fournir deux sorties en quadrature de phase l'une par rapport à l'autre, appliquées respectivement aux entrées des deux mélangeurs. De manière classique, les mélangeurs peuvent comporter plusieurs étages de conversion pour passer progressivement et non en une seule fois de la bande de base à la fréquence porteuse.

Les mélangeurs reçoivent par ailleurs les signaux de modulation en bande de base déphasés ; ils sont donc reliés chacun à une sortie respective du déphaseur PH1a, PH1b.

Les signaux de sortie à fréquence porteuse issus des mélangeurs et recombinés l'un avec l'autre, sont appliqués à l'entrée de l'amplificateur PA.

Un circuit de transposition de fréquence identique au précédent est prévu dans la voie de réception. Il comprend deux mélangeurs M2i et M2q (à un ou pusieurs étages) recevant la sortie de l'amplificateur de réception à faible bruit LNA. Les mélangeurs reçoivent par ailleurs la fréquence porteuse de référence issue de l'oscillateur à asservissement de phase PLL. C'est la même fréquence que pour l'émission. Cette fréquence porteuse est appliquée au mélangeur M2i, et appliquée après déphasage de 90° au mélangeur M2q. Les sorties des mélangeurs sont appliquées aux entrées du déphaseur commandable PH2a, PH2b. Les sorties en phase et en quadrature de phase du déphaseur PH2a, PH2b sont appliquées aux bornes de sortie S2i et S2q respectivement.

L'oscillateur PLL est calé en fréquence et en phase sur le signal d'horloge CLK qu'il reçoit. La fréquence porteuse Fp qu'il produit est un multiple de la fréquence d'horloge ; elle est la même pour tous les circuits 14 puisque ceux-ci reçoivent tous la même fréquence d'horloge ; un signal d'asservissement est obtenu dans chaque circuit intégré 14 par division de la fréquence porteuse et asservissement de phase sur la phase de la fréquence d'horloge. Les phases des porteuses ainsi produites dans les différents circuits intégrés peuvent être différentes les unes des autres si les oscillateurs PLL sont différents et également si les circuits intégrés reçoivent une horloge avec des écarts de phase les uns par rapport aux autres.

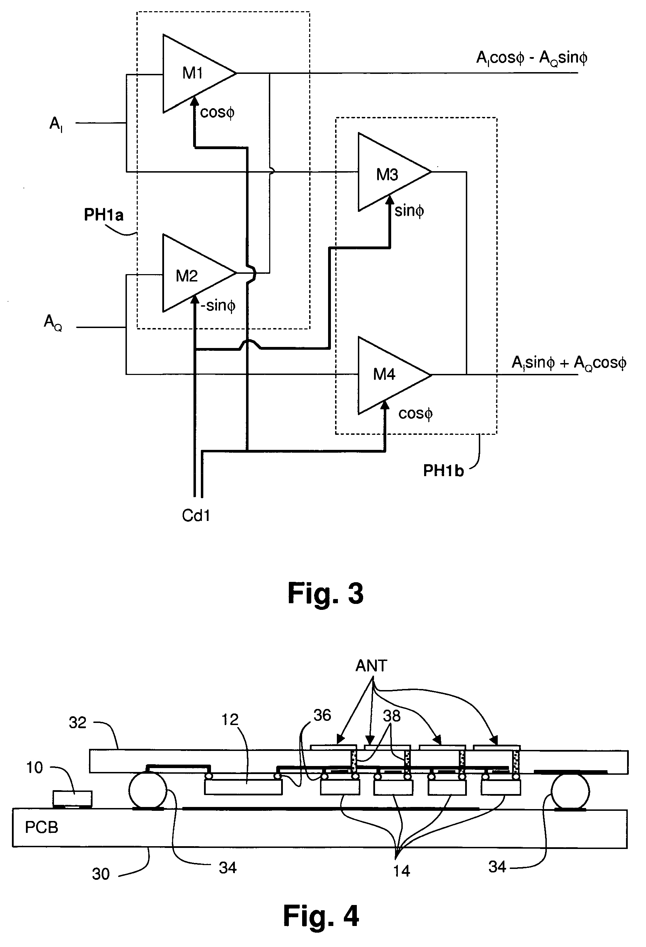

La figure 3 représente schématiquement la constitution d'un déphaseur commandable. Il reçoit des signaux $A_I$ et $A_Q$ en quadrature de phase, par exemple les signaux reçus sur les entrées E1i et E1q, et il reçoit une commande numérique de réglage du déphasage $\phi$. Cette commande est appliquée sous forme de deux valeurs de gain à deux groupes d'amplificateurs à gain commandable M1, M2 et M3, M4. Les amplificateurs M1 et M2 constituent un groupe et correspondent au déphaseur PH1a de la figure 2. Les amplificateurs M3 et M4 constituent un autre groupe correspondant au déphaseur PH1b de la figure 2. Les deux groupes reçoivent les signaux $A_I$ et $A_Q$ en quadrature de phase et chacun des groupes produit un signal de sortie respectif, déphasé de $\phi$ par rapport à l'entrée et en quadrature de phase avec le signal de sortie de l'autre groupe.

Plus précisément, l'amplificateur M1 reçoit le signal $A_I$ et la commande numérique de gain lui impose un gain ayant une valeur $\cos\phi$ ; l'amplificateur M2 reçoit le signal $A_Q$ et la commande numérique lui impose un gain de valeur $-\sin\phi$. Les sorties des deux amplificateurs sont combinées pour produire un signal d'amplitude $A_I\cos\phi - A_Q\sin\phi$. Pour l'autre déphaseur PH1b : l'amplificateur M3 reçoit le signal $A_I$ et la commande numérique de gain lui impose un gain $\sin\phi$ ; l'amplificateur M2 reçoit le signal $A_Q$ et la commande numérique lui impose un gain $+\cos\phi$. Les sorties des deux amplificateurs sont combinées pour produire un signal d'amplitude $A_I\sin\phi + A_Q\cos\phi$.

Les sorties des deux déphaseurs représentent le signal $A_I$, $A_Q$ déphasé de $\phi$ par rapport au signal à l'entrée du déphaseur.

Si on veut un déphasage entre 0 et 45° par pas de 11,25 degrés ($\pi/16$), on peut utiliser 5 valeurs de cosinus pour les amplificateurs ayant pour gain un cosinus, et 5 valeurs de sinus pour les amplificateurs ayant pour gain un sinus. Pour un déphasage au-delà de 45°, on peut utiliser des commutateurs pour croiser les connexions des amplificateurs (par exemple échanger les amplificateurs qui ont un gain en sinus avec les amplificateurs qui ont un gain en cosinus). Ceci permet de limiter à cinq les valeurs de gain possibles des différents amplificateurs, tout en permettant un déphasage entre 0° et 360°.

La figure 4 représente schématiquement la constitution physique préférée du système dont l'architecture générale vient d'être décrite.

L'ensemble du système est monté sur une plaque de circuit imprimé 30 en matière plastique ou céramique portant des conducteurs d'interconnexion. Une plaquette intermédiaire 32 en silicium est soudée sur la plaque 30 par l'intermédiaire de billes de soudure 34. La plaquette de silicium porte également sur sa face inférieure (face tournée vers la plaque 30) un réseau de conducteurs d'interconnexion, de préférence un réseau multicouches formé par des processus de dépôt et gravure classiques de microélectronique. La puce de circuit intégré 12 (traitement de signal en bande de base et processeur de commande) et les circuits intégrés 14 (circuits d'émission-réception) sont soudés sur cette face inférieure. La soudure est une soudure flip-chip par des billes de faible hauteur 36. Les billes de soudure 34 qui relient la plaquette de silicium 32 à la plaque 30 sont plus hautes que les billes 36 et elles servent d'entretoises pour établir entre la plaque 30 et la plaquette 32 un espace suffisant pour loger les circuits intégrés 12 et 14, y compris l'épaisseur des billes de soudure 36.

La plaquette de silicium 32 est en silicium de haute résistivité, donc bien isolant, permettant de servir de substrat pour des antennes de type patch. Les antennes patch ANT comprennent des portions métalliques déposées et gravées sur la face supérieure de la plaquette. Des vias conducteurs 38 sont formés à travers toute l'épaisseur de la plaquette, pour relier ces antennes patch aux circuits intégrés 14, directement si le via est formé au-dessus d'une bille de soudure 36, ou indirectement à travers le réseau d'interconnexions de face arrière de la plaquette 32.

L'espacement entre les centres des antennes ANT adjacentes est de préférence égal ou environ égal à la demi-longueur d'onde de la fréquence porteuse, pour faciliter la formation d'un faisceau de rayonnement cohérent dans une direction de l'espace.

Un ou plusieurs plans de masse peuvent être formés dans le réseau d'interconnexions de face arrière en regard des antennes patch ANT.

Des vias conducteurs en réseau serré, tous reliés à un plan de masse, peuvent aider à former une cavité électromagnétique en arrière de l'antenne, aidant au rayonnement de celle-ci.

Le quartz de stabilisation de la fréquence d'horloge, extérieur aux circuits intégrés, peut être placé directement sur la plaque de circuit imprimé 30.

La commande de déphasage de chaque circuit intégré 14, à l'émission comme à la réception, est établie par le circuit de traitement 12, en fonction d'un processus de mesure dont la fonction est de déterminer quel est la meilleure direction de faisceau qu'il convient de donner à l'antenne globale (ensemble des antennes ANT émettant en parallèle le même signal modulé plus ou moins déphasé) pour maximiser le budget de puissance de la liaison.

Selon les normes en vigueur, une communication est précédée d'abord d'un protocole d'observation des puissances reçues, qui est un dialogue entre deux systèmes en communication. Par ce protocole, on détermine la meilleure répartition à donner aux déphasages d'antenne. Puis on poursuit la communication avec cette répartition et on vérifie régulièrement cette répartition, en l'ajustant si nécessaire, par un protocole de suivi.

Etant donné que chaque circuit intégré d'émission-réception possède sa propre synthèse de fréquence, avec des décalages de phase inévitables, on effectuera de préférence une calibration préalable pour déterminer et compenser ces décalages, afin que la commande numérique des déphaseurs aboutisse à la formation d'un faisceau cohérent dans une direction de l'espace malgré ces décalages. On déterminera donc dans cette phase de calibration quels décalages de compensation doivent être systématiquement appliqués par les déphaseurs en plus des déphasages liés à la directivité de diagramme de rayonnement souhaitée. Les décalages de compensation, ou déphasages propres des circuits intégrés, sont liés à la fois à la constitution du circuit intégré et à leur position dans le système puisque les longueurs de connexion jouent un rôle dans ces déphasages.

Le système comporte de préférence (figure 2) une mémoire MEM (représentée en pointillés) contenant les déphasages propres des différents circuits intégrés qui ont été obtenus dans la phase de calibration, et un circuit DPH de calcul des commandes de déphasage. Le circuit de calcul utilise les données de la mémoire ainsi que des déphasages de consigne de directivité, pour produire les signaux de commandes de déphasage appliqués aux bornes Cd1, Cd2 (mentionnées en référence à la figure 2) du circuit intégré. La mémoire MEM ainsi que le circuit de calcul DPH des commandes de déphasage font de préférence partie du circuit de traitement commun. Dans une variante de réalisation, on pourrait envisager que la mémoire MEM et le circuit de calcul soient répartis dans les circuits intégrés, les bornes de commande de déphasage Cd1, Cd2 recevant les consignes et le calcul de la commande de déphasage compensé étant fait à l'intérieur du circuit intégré.

Dans la phase de calibration, on va faire fonctionner simultanément les amplificateurs d'émission et de réception. L'isolation entre les voies émission et réception n'est pas parfaite, en particulier à l'endroit du commutateur d'antenne SW ; par conséquent la voie de réception recueillera une fraction, par exemple -30dB, du signal émis ; cette fraction sera recueillie par la voie de réception et servira à la calibration ; pour un signal émis à 0dBm, la fraction renvoyée, 30dBm, est suffisante pour la mesure. S'il n'y a pas de commutateur d'antenne, un coupleur directif peut être prévu dans la voie d'émission pour prélever une petite partie du signal à émettre et l'envoyer vers la voie de réception à des fins de calibration.

Le signal subit un déphasage différent dans les différents circuits intégrés 14 à cause des différences de phase des fréquences synthétisées.

Le signal recombiné sur les sorties des N circuits intégrés s'écrit :

$$s_r(t) = s(t) \sum_{k=1}^{N} e^{j(2*\varphi_{OLk} + \varphi_{Txk} + \varphi_{Rxk} + \omega\tau)}$$

avec S(t) le signal signal émis, $S_r(t)$ le signal recombiné, $\omega$ la pulsation, $\varphi_{OLk}$ le déphasage propre de la synthèse de fréquence du circuit-intégré 14 de rang k (k=1 à N), c'est-à-dire le déphasage (rapporté à la fréquence porteuse) entre le signal d'horloge et la sortie de l'oscillateur PLL, $\varphi_{Pxk}$ et $\varphi_{Rxk}$ les déphasages appliqués aux déphaseurs des voies d'émission et de réception de ce circuit, et $\tau$ le délai de propagation de l'onde en bande millimétrique dans le circuit d'émission-réception en mode rebouclé.

Par une séquence de test ou d'apprentissage, en faisant varier les déphasages appliqués à l'émetteur et/ou au récepteur, on peut obtenir par calibration les déphasages relatifs entre les synthèses de fréquence.

Une première méthode de calibration peut consister à faire varier les déphasages des déphaseurs à l'émission puis à la réception en leur donnant toutes sortes de valeurs possibles $\varphi_{Txi}$ (émission) et $\varphi_{Rxi}$ (réception) jusqu'à obtenir un signal constructif :

$$\max_{\varphi_{Txi}, \varphi_{Rxi}} \left( \int_0^T \left\| s(t) \sum_{k=1}^{N} e^{j(2*\varphi_{OLk} + \varphi_{Txi} + \varphi_{Rxi} + \omega k\tau)} \right\| \right)$$

Cette solution peut demander un long temps d'intégration, puisque qu'il faut évaluer la puissance reçue dans chacune des $(2*N^2)$ configurations sur un temps d'intégration T s'il y a N circuits d'émission-réception.

Une méthode préférable à la précédente consiste à estimer directement les déphasages relatifs entre les voies en appliquant aux voies d'émission et de réception un nombre limité de jeux de déphasages ayant des propriétés d'orthogonalité mutuelle. On peut par exemple utiliser comme jeu de déphasages successifs les colonnes d'une matrice de Hadamard NxN, les colonnes d'une telle matrice ayant la propriété d'être des vecteurs orthogonaux entre eux (produit d'un vecteur ligne par un vecteur colonne nul sauf si le rang de la ligne et de la colonne sont identiques).

Exemple de matrice d'Hadamard pour N=8 voies :

$$H = \begin{bmatrix} 1 & 1 & 1 & 1 & 1 & 1 & 1 & 1 \\ 1 & -1 & 1 & -1 & 1 & -1 & 1 & -1 \\ 1 & 1 & -1 & -1 & 1 & 1 & -1 & -1 \\ 1 & -1 & -1 & 1 & 1 & -1 & -1 & 1 \\ 1 & 1 & 1 & 1 & -1 & -1 & -1 & -1 \\ 1 & -1 & 1 & -1 & -1 & 1 & -1 & 1 \\ 1 & 1 & -1 & -1 & -1 & -1 & 1 & 1 \\ 1 & -1 & -1 & 1 & -1 & 1 & 1 & -1 \end{bmatrix}$$

Pour N circuits-intégrés d'émission réception 14, on applique N échantillons de signal de test (ou même plusieurs fois N échantillons si on veut affiner la mesure par un moyennage des résultats). Pour un échantillon on commande les déphaseurs des N voies d'émission selon un jeu de N valeurs de déphasage correspondant à une colonne de la matrice ; pour l'échantillon suivant on commande les déphaseurs selon un autre jeu correspondant à une autre colonne ; et ainsi de suite : on utilise les N jeux de déphasages possibles, c'est-à-dire les N colonnes de la matrice H, et les jeux sont orthogonaux les uns par rapport aux autres.

La valeur 1 représente un déphasage nul ; la valeur -1 représente un déphasage de 180°. On pourrait choisir d'autres valeurs, mais ces valeurs sont celles qui simplifient le plus les calculs.

Sur les voies de réception on applique de préférence toujours le même jeu qui est la première colonne de la matrice, à savoir des déphasages identiques et tous nuls.

On recueille pour chaque échantillon de signal émis un échantillon correspondant de signal reçu, ce qui veut dire qu'on fait fonctionner la voie de réception en même temps que la voie d'émission comme on l'a expliqué précédemment.

A un vecteur X de N valeurs de signal d'émission, on fait donc correspondre un vecteur Y de N valeurs de signal reçu.

Le circuit intégré 12 comporte les moyens pour émettre le vecteur X de N échantillons sur toutes les voies à la fois, en bande de base, les moyens pour modifier à chaque fois les déphasages des N voies d'émission, et les moyens pour effectuer les calculs de déphasage des fréquences porteuses à partir de la matrice d'Hadamard, du vecteur X et du vecteur Y. Les vecteurs X et Y sont supposés ramenés en amplitude à une valeur unitaire.

Si les déphasages de fréquence porteuse des N circuits intégrés sont représentés par un vecteur $\Phi$ à N composantes, on peut écrire :

$$Y = X \otimes H.\Phi$$

Le point dans cette équation désigne une multiplication matricielle, le $\otimes$ étant une multiplication terme à terme.

Les déphasages du vecteur $\Phi$ représentent principalement le double du déphasage propre introduit par l'oscillateur puisque ce déphasage se produit à l'émission et à la réception. Le déphasage propre est compté par rapport au signal d'horloge CLK. On suppose ici que le déphasage introduit par le retard de propagation de l'horloge d'un circuit à un autre est négligeable, le calcul étant un peu plus compliqué si on veut en tenir compte, surtout s'il n'est pas identique pour tous les circuits.

Du fait de l'orthogonalité de la matrice H, on peut écrire, en multipliant l'équation précédente par la transposée $^tH$ de cette matrice :

$$^{t}H.Y = X \otimes N.I_{N}.\Phi$$

où $I_N$ est la matrice identité NxN

De cette équation on tire directement le vecteur de déphasage $\Phi$ :

$$\Phi = (1/2N)^{t}H.Y \otimes (1/X),$$

où 1/X désigne un vecteur dont chaque composante est l'inverse d'une composante respective du vecteur d'échantillons X ; le point désigne encore une multiplication matricielle et le symbole $\otimes$ une multiplication terme à terme.

La complexité du calcul est modérée du fait que la matrice d'Hadamard ne comprend que des valeurs simples +1 et -1.

On notera qu'une méthode semblable peut être appliquée aussi pour calibrer les variations de gain qui peuvent exister entre les différentes voies d'émission ou réception.

A la suite de cette calibration, le circuit de traitement 12 mémorise les valeurs de déphasage propres des différents circuits intégrés 14 et tient compte de ces déphasages pour appliquer ultérieurement des consignes de déphasage en vue de former un faisceau cohérent dans une direction donnée de l'espace : le processeur retranche la valeur de déphasage propre du circuit intégré de la valeur de consigne qu'il devrait appliquer à ce circuit s'il n'y avait pas ce déphasage propre.

Typiquement, les valeurs de déphasage qu'on veut appliquer sont des valeurs variant par pas de 22°5 ($\pi/8$), avec une précision de + ou - 12° en phase et + ou - 1 dB en gain.

La phase de calibration peut être exécutée avec des algorithmes contenus dans le système d'émission-réception (dans le circuit de traitement commun) ou avec des algorithmes d'un banc de test du système. Dans les deux cas, les déphasages mesurés restent présents dans la mémoire MEM du système d'émission-réception.

**Revendications**

1. Système d'émission-réception en bande millimétrique sans contact pour une transmission de données à haut débit, comprenant un circuit de traitement commun (12) fournissant des signaux de modulation et plusieurs circuits intégrés d'émission-réception (14) tous identiques les uns aux autres, reliés électriquement au circuit de traitement commun pour en recevoir les signaux de modulation et recevant par ailleurs tous un signal d'horloge (CLK) issu d'une source de signal d'horloge commune, les circuits intégrés d'émission-réception comportant chacun :

   - un oscillateur (PLL) asservi sur le signal d'horloge pour produire une fréquence porteuse (Fp) multiple du signal d'horloge,
   - une voie d'émission comportant un premier circuit de déphasage commandable (PH1 a, PH1 b), un premier circuit de transposition de fréquence (M1i, M1q) vers la fréquence porteuse, et un amplificateur de puissance (PA),
   - une voie de réception comportant un amplificateur à faible bruit (LNA), un deuxième circuit de transposition de fréquence (M2i, M2q) depuis la fréquence porteuse, et un deuxième circuit de déphasage commandable (PH2a, PH2b),

   le système comportant également pour chaque circuit intégré d'émission-réception (14) au moins une antenne respective (ANT) reliée aux voies d'émission et de réception de ce circuit.

2. Système d'émission selon la revendication 1, **caractérisé en ce que** l'antenne est située sur le circuit intégré d'émission-réception.

3. Système d'émission-réception selon la revendication 1, **caractérisé en ce que** l'antenne est située hors du circuit intégré d'émission-réception et est reliée à une borne de connexion d'antenne du circuit intégré.

4. Système selon l'une des revendications 1 à 3, **caractérisé en ce que** le circuit intégré d'émission-réception comporte un commutateur émission/réception relié à la borne de connexion d'antenne pour relier cette borne soit à la sortie de l'amplificateur de puissance de la voie d'émission soit à l'entrée de l'amplificateur à faible bruit de la voie de réception.

5. Système selon l'une des revendications 1 à 4, **caractérisé en ce que** les circuits intégrés d'émission-réception (14) sont reportés sur une face arrière d'une plaquette de silicium à haute résistivité (32) comportant sur cette face arrière un réseau de conducteurs d'interconnexion reliés aux circuits intégrés, les antennes (ANT) étant formées sur la face avant et étant reliées au réseau de conducteurs par des vias conducteurs (38) traversant toute l'épaisseur de la plaquette.

6. Système selon l'une des revendications précédentes, **caractérisé en ce que** chaque circuit-intégré d'émission-réception (14) comporte un contrôle de gain à l'émission et à la réception pour optimiser la consommation lorsqu'il n'est pas nécessaire d'utiliser toute la puissance d'émission disponible.

7. Système selon l'une des revendications précédentes, **caractérisé en ce que** des moyens sont prévus dans chaque circuit-intégré d'émission-réception pour couper l'alimentation des amplificateurs lorsqu'il n'est pas nécessaire d'utiliser tous les circuits en émission ou en réception.

8. Système selon l'une des revendications précédentes, **caractérisé en ce que** le circuit de traitement commun comprend des moyens pour déterminer dans une phase de calibration les déphasages propres de fréquence porteuse des différents circuits intégrés, liés à leur constitution et à leur position dans le système.

9. Système selon la revendication 8, **caractérisé en ce qu'**il comprend une mémoire (MEM) pour stocker les déphasages déterminés pendant la phase de calibration.

10. Système selon l'une des revendications 8 et 9, **caractérisé en ce que** les moyens de détermination des déphasages propres de fréquence porteuse comprennent

- des moyens pour appliquer à la voie d'émission des N circuits une séquence de N échantillons successifs de signaux de test, représentée par un vecteur X à N composantes,
- des moyens pour appliquer un jeu de N déphasages simples aux N circuits de déphasage des voies d'émission au moment de l'émission d'un échantillon, le jeu de N déphasages simples étant choisi parmi N jeux possibles différents les uns des autres et orthogonaux les uns par rapport aux autres, les N jeux étant appliqués successivement, simultanément avec l'application des N échantillons de la séquence,
- des moyens pour recueillir un vecteur Y de N échantillons successifs de signal correspondants sur la voie de réception couplée à la voie d'émission,
- et des moyens pour calculer un vecteur Φ de déphasages des fréquences porteuses des N circuits par une équation $\Phi = (1/2N)^tH.Y \otimes (1/X)$, où $^tH$ désigne la transposée d'une matrice H représentant les N jeux possibles de N déphasages, 1/X désigne un vecteur dont les composantes sont l'inverse de chacune des composantes du vecteur X, et le symbole $\otimes$ désigne une multiplication terme à terme des composantes de vecteurs.

11. Procédé d'utilisation d'un système d'émission-réception en bande millimétrique sans contact pour une transmission de données à haut débit, comprenant un circuit de traitement commun (12) fournissant des signaux de modulation et plusieurs circuits intégrés (14) d'émission-réception tous identiques les uns aux autres, reliés électriquement au circuit de traitement commun pour en recevoir les signaux de modulation et recevant par ailleurs tous un signal d'horloge (CLK) issu d'une source de signal d'horloge commune, les circuits intégrés étant reliés chacun à au mois une antenne respective (ANT) et comprenant chacun une boucle à asservissement de phase, des circuits de transposition de fréquence et des circuits de déphasage commandables (PH1A, PH1 B), procédé **caractérisé en ce qu'**il comprend une étape de calibration pour la détermination de déphasages propres des différents circuits-intégrés, liés à la constitution et à la position des circuits intégrés dans le système, une mise en mémoire de ces déphasages, et une utilisation ultérieure des déphasages mis en mémoire, pour modifier des commandes de déphasage fournies aux circuits intégrés par le circuit de traitement commun.

## Patentansprüche

1. Kontaktloses Millimeterband-Sende-/Empfangssystem für eine Datenübertragung mit hohem Durchsatz, das eine gemeinsame Verarbeitungsschaltung (12) umfasst, die Modulationssignale liefert, und mehrere integrierte Sende-/Empfangsschaltungen (14), die alle miteinander identisch und mit der gemeinsamen Verarbeitungsschaltung elektrisch verbunden sind, um die Modulationssignale zu empfangen, und die ferner alle ein von einer gemeinsamen Taktsignalquelle kommendes Taktsignal (CLK) empfangen, wobei die integrierten Sende-/Empfangsschaltungen jeweils Folgendes umfassen:

   - einen auf das Taktsignal gerasteten Oszillator (PLL), um eine mehrfache Trägerfrequenz (Fp) des Taktsignals zu erzeugen;
   - einen Sendekanal, der eine erste steuerbare Phasenverschiebungsschaltung (PH1a, PH1b), eine erste Schaltung (M1i, M1q) zum Transponieren der Frequenz auf die Trägerfrequenz und einen Leistungsverstärker (PA) umfasst;
   - einen Empfangskanal, der einen Low-Noise-Verstärker (LNA), eine zweite Schaltung (M2i, M2q) zum Transponieren der Frequenz von der Trägerfrequenz und eine zweite steuerbare Phasenverschiebungsschaltung (PH2a, PH2b) umfasst,

   wobei das System ferner, für jede integrierte Sende-/Empfangsschaltung (14), wenigstens eine jeweilige Antenne (ANT) umfasst, die mit den Sende- und Empfangskanälen dieser Schaltung verbunden ist.

2. Sendesystem nach Anspruch 1, **dadurch gekennzeichnet, dass** sich die Antenne auf der integrierten Sende-/Empfangsschaltung befindet.

3. Sende-/Empfangssystem nach Anspruch 1, **dadurch gekennzeichnet, dass** sich die Antenne außerhalb der integrierten Sende-/Empfangsschaltung befindet und mit einem Antennenanschluss der integrierten Schaltung verbunden ist.

4. System nach einem der Ansprüche 1 bis 3, **dadurch gekennzeichnet, dass** die integrierte Sende-/Empfangsschaltung einen mit dem Antennenanschluss verbundenen Sende-/Empfangsschalter zum Verbinden dieses Anschlusses entweder mit dem Ausgang des Leistungsverstärkers des Sendekanals oder mit dem Eingang des Low-Noise-Verstärkers des Empfangskanals umfasst.

**5.** System nach einem der Ansprüche 1 bis 4, **dadurch gekennzeichnet, dass** die integrierten Sende-/Empfangsschaltungen (14) auf einer Rückseite eines Hochwiderstandssiliciumwafers (32) platziert sind, der auf dieser Rückseite ein Netzwerk von Verbindungsleitern umfasst, die mit den integrierten Schaltungen verbunden sind, wobei die Antennen (ANT) auf der Vorderseite ausgebildet und mit dem Netzwerk von Leitern durch leitende Durchkontaktierungen (38) verbunden ist, die durch die gesamte Dicke der Platte verlaufen.

**6.** System nach einem der vorherigen Ansprüche, **dadurch gekennzeichnet, dass** jede integrierte Sende-/Empfangsschaltung (14) eine Verstärkungsregelung beim Senden und beim Empfangen zum Optimieren des Verbrauchs umfasst, wenn es nicht notwendig ist, die gesamte verfügbare Sendeleistung zu benutzen.

**7.** System nach einem der vorherigen Ansprüche, **dadurch gekennzeichnet, dass** Mittel in jeder integrierten Sende-/Empfangsschaltung zum Beschränken der Speisung der Verstärker vorgesehen sind, wenn es nicht notwendig ist, dass alle Schaltungen beim Senden oder beim Empfangen benutzt werden.

**8.** System nach einem der vorherigen Ansprüche, **dadurch gekennzeichnet, dass** die gemeinsame Verarbeitungsschaltung Mittel zum Ermitteln, in einer Phase des Kalibrierens der spezifischen Trägerfrequenzphasenverschiebungen der verschiedenen integrierten Schaltungen umfasst, die mit ihrem Aufbau und ihrer Position im System verbunden sind.

**9.** System nach Anspruch 8, **dadurch gekennzeichnet, dass** es Speicher (MEM) zum Speichern der in der Kalibrationsphase ermittelten Phasenverschiebungen umfasst.

**10.** System nach einem der Ansprüche 8 bis 9, **dadurch gekennzeichnet, dass** die Mittel zum Ermitteln von spezifischen Frequenzträgerphasenverschiebungen Folgendes umfassen:

- Mittel zum Anlegen einer Folge von N aufeinander folgenden Prüfsignalsamples, repräsentiert durch einen Vektor X mit N Komponenten, an den Sendekanal der N Schaltungen;
- Mittel zum Anlegen eines Satzes von einfachen Phasenverschiebungen N an die N-Phasenverschiebungsschaltungen der Sendekanäle im Moment des Sendens eines Sample, wobei der Satz von N einfachen Phasenverschiebungen aus N möglichen Sätzen ausgewählt wird, die sich voneinander unterscheiden und die orthogonal zueinander sind, wobei die N Sätze aufeinander folgend zur selben Zeit angelegt werden, zu der die N Samples der Folge angelegt werden;
- Mittel zum Einholen eines Vektors Y von N aufeinander folgenden Samples von entsprechenden Signalen auf dem mit dem Sendekanal gekoppelten Empfangskanal; und
- Mittel zum Berechnen eines Vektors $\phi$ von Phasenverschiebungen der Trägerfrequenzen der N Schaltungen mittels einer Gleichung $\phi=(1/2N)^tH.Y\otimes(1/X)$, wobei $^tH$ die Transponierte einer Matrix H bezeichnet, die die N möglichen Sätze von N Phasenverschiebungen repräsentiert, 1/X einen Vektor bezeichnet, dessen Komponenten die Umkehr jeder der Komponenten des Vektors X ist, und das Symbol $\otimes$ eine Term-für-Term-Multiplikation der Vektorkomponenten bezeichnet.

**11.** Verfahren zum Verwenden eines kontaktlosen Millimeterband-Sende-/Empfangssystems für eine Datenübertragung mit hohem Durchsatz, das eine gemeinsame Verarbeitungsschaltung (12) zum Liefern von Modulationssignalen und mehrere integrierte Sende-/Empfangsschaltungen (14) umfasst, die alle miteinander identisch und mit der gemeinsamen Verarbeitungsschaltung elektrisch verbunden sind, um die Modulationssignale zu empfangen, wobei alle auch ein von einer gemeinsamen Taktsignalquelle kommendes Taktsignal (CLK) empfangen, wobei die integrierten Schaltungen jeweils mit wenigstens einer jeweiligen Antenne (ANT) verbunden sind und jeweils einen Phasenregelkreis, Frequenztranspositionsschaltungen und steuerbare Phasenverschiebungsschaltungen (PH1A, PH1B) umfassen, wobei das Verfahren **dadurch gekennzeichnet ist, dass** es einen Schritt des Kalibrierens zum Ermitteln von spezifischen Phasenverschiebungen der verschiedenen integrierten Schaltungen, verbunden mit dem Aufbau und der Position der integrierten Schaltungen in dem System, des Speicherns dieser Phasenverschiebungen in einem Speicher und nachfolgend des Benutzens der in einem Speicher gespeicherten Phasenverschiebungen zum Modifizieren von Phasenverschiebungsbefehlen beinhaltet, die von der gemeinsamen Verarbeitungsschaltung zu den integrierten Schaltungen gespeist werden.

**Claims**

**1.** A contactless millimetre band transmission-reception system for a high bit-rate data transmission, comprising a common processing circuit (12) feeding modulation signals and a plurality of integrated transmission-reception circuits (14), all of which are identical with each other, electrically connected to said common processing circuit so as to receive said modulation signals and also all receiving a clock signal (CLK) coming from a common clock signal feed, said integrated transmission-reception circuits each comprising:

- an oscillator (PLL) locked onto the clock signal so as to produce a multiple carrier frequency (Fp) of the clock signal;
- a transmission channel comprising a first controllable phase-shifting circuit (PH1a, PH1b), a first circuit (M1i, M1q) for transposing frequency to the carrier frequency and a power amplifier (PA);
- a reception channel comprising a low noise amplifier (LNA), a second circuit (M2i, M2q) for transposing frequency from the carrier frequency and a second controllable phase-shifting circuit (PH2a, PH2b),

said system further comprising, for each integrated transmission-reception circuit (14), at least one respective antenna (ANT) connected to said transmission and reception channels of said circuit.

2. The transmission system according to claim 1, **characterised in that** said antenna is located on said integrated transmission-reception circuit.

3. The transmission-reception system according to claim 1, **characterised in that** said antenna is located outside of said integrated transmission-reception circuit and is connected to an antenna connection terminal of said integrated circuit.

4. The system according to any one of claims 1 to 3, **characterised in that** said integrated transmission-reception circuit comprises a transmission-reception switch connected to said antenna connection terminal so as to connect said terminal either to the output of said power amplifier of said transmission channel or to the input of said low noise amplifier of said reception channel.

5. The system according to any one of claims 1 to 4, **characterised in that** said integrated transmission-reception circuits (14) are placed on a rear face of a high resistance silicon plate (32) comprising, on said rear face, a network of interconnection conductors connected to said integrated circuits, said antennae (ANT) being formed on the front face and being connected to said network of conductors by conducting vias (38) passing through the entire thickness of said plate.

6. The system according to any one of the preceding claims, **characterised in that** each integrated transmission-reception circuit (14) comprises a gain control on transmission and on reception for optimising consumption when not all of the available transmission power needs to be used.

7. The system according to any one of the preceding claims, **characterised in that** means are provided in each integrated transmission-reception circuit for cutting the power to the amplifiers when it is no longer necessary for all of the circuits to be used in transmission or in reception.

8. The system according to any one of the preceding claims, **characterised in that** said common processing circuit comprises means for determining, during a calibration phase, the specific carrier frequency phase-shifts of the various integrated circuits, which phase-shifts are associated with their constitution and with their position in the system.

9. The system according to claim 8, **characterised in that** it comprises a memory (MEM) for storing the phase-shifts determined during the calibration phase.

10. The system according to any one of claims 8 to 9, **characterised in that** said means for determining specific carrier frequency phase-shifts comprise:

- means for applying a sequence of N successive samples of test signals, represented by a vector X with N components, to the transmission channel of the N circuits;
- means for applying a set of simple phase-shifts N to the N phase-shifting circuits of said transmission channels when a sample is transmitted, said set of N simple phase-shifts being selected from among N possible sets that are different from one another and are orthogonal relative to each other, said N sets being successively applied, at the same time as said N samples of said sequence are applied;

- means for gathering a vector Y of N successive samples of corresponding signals on said reception channel coupled to said transmission channel; and
- means for computing a vector $\phi$ of phase-shifts of the carrier frequencies of said N circuits using an equation $\phi = (1/2N)^t H.Y \otimes (1/X)$, where $^t H$ designates the transpose of a matrix H representing said N possible sets of N phase-shifts, 1/X designates a vector, the components of which are the inverse of each component of the vector X and the symbol $\otimes$ designates a term-by-term multiplication of the components of vectors.

11. A method for using a contactless millimetre band transmission-reception system for a high bit-rate data transmission, comprising a common processing circuit (12) feeding modulation signals and a plurality of integrated transmission-reception circuits (14), all of which are identical with each other, electrically connected to said common processing circuit so as to receive said modulation signals and also all receiving a clock signal (CLK) coming from a common clock signal feed, said integrated circuits each being connected to at least one respective antenna (ANT) and each comprising a phase-locked loop, frequency transposition circuits and controllable phase-shifting circuits (PH1A, PH1B), said method being **characterised in that** it comprises a calibration step for determining specific phase-shifts of the various integrated circuits, which phase-shifts are associated with the constitution and with the position of said integrated circuits in said system, storing said phase-shifts in a memory and subsequently using said phase-shifts that are stored in a memory to modify phase-shifting commands that are fed to said integrated circuits by said common processing circuit.

**Fig. 1**

**Fig. 2**

$A_I \cos\phi - A_Q \sin\phi$

$A_I \sin\phi + A_Q \cos\phi$

**Fig. 3**

**Fig. 4**

**EP 2 828 976 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2010159829 A
- US 7808798 B
- US 20090061795 A
- EP 1486796 A
- EP 1132754 A
- US 2011254527 A